# EUROPÄISCHE PATENTSCHRIFT

(11) **EP 1 118 116 B1**
(45) Veröffentlichungstag und Bekanntmachung des Hinweises auf die Patenterteilung: **03.01.2007**
(21) Anmeldenummer: 99953640.2
(22) Anmeldetag: 01.09.1999
(51) Int. Cl.: H01L 21/8242, H01L 27/108

(54) **SUBSTRAT MIT EINER VERTIEFUNG, DAS FÜR EINE INTEGRIERTE SCHALTUNGSANORDNUNG GEEIGNET IST, UND VERFAHREN ZU DESSEN HERSTELLUNG**
SUBSTRATE WITH AN INDENTATION FOR AN INTEGRATED CIRCUIT DEVICE AND METHOD FOR THE PRODUCTION THEREOF
SUBSTRAT DOTE D'UN CREUX ADAPTE A UNE CONFIGURATION DE CIRCUIT INTEGRE ET SON PROCEDE DE PRODUCTION

(30) Priorität: 30.09.1998 DE 19844967
(43) Veröffentlichungstag der Anmeldung: 25.07.2001
(73) Patentinhaber: Infineon Technologies AG, 81669 München (DE)
(72) Erfinder: WILLER, Josef, D-85521 Riemerling (DE); HOFMANN, Franz, D-80995 München (DE); SCHLÖSSER, Till, D-81825 München (DE)
(74) Vertreter: Kottmann, Heinz Dieter
(86) Internationale Anmeldenummer: PCT/DE1999/002724
(87) Internationale Veröffentlichungsnummer: WO 2000/019525

(56) Entgegenhaltungen:
- EP-A- 0 333 426
- DE-C- 19 519 160
- US-A- 5 216 266
- US-A- 5 302 541
- US-A- 5 365 097
- US-A- 5 376 575
- US-A- 5 559 353
- YAMADA K ET AL: "A deep-trenched capacitor technology for 4 megabit dynamic RAM" INTERNATIONAL ELECTRON DEVICES MEETING. TECHNICAL DIGEST (CAT. NO. 85CH2252-5), WASHINGTON, DC, USA, 1-4 DEC. 1985, Seiten 702-705, XP002128108 1985, New York, NY, USA, IEEE, USA in der Anmeldung erwähnt

## Beschreibung

Substrat mit einer Vertiefung, das für eine integrierte Schaltungsanordnung geeignet ist, und Verfahren zu dessen Herstellung.

Die Erfindung bezieht sich auf ein Substrat mit einer Vertiefung, das für eine integrierte Schaltungsanordnung geeignet ist, und auf ein Verfahren zu dessen Herstellung.

In K. Yamada et al "A deep-trenched capacity technology for 4 megabit dynamic RAM", IEDM (1985) 702, wird ein in einer Vertiefung eines Substrats angeordneter Kondensator beschrieben, bei der ein Kondensatordielektrikum an Flächen erzeugt wird, die keine Kanten aufweisen. Die Vertiefung wird zunächst mit einem quadratischen Querschnitt durch ein photolithographisches Verfahren erzeugt. Zur Abrundung der Kanten wird ein ca. 50 nm dickes thermisches Oxid aufgewachsen und anschließend entfernt. Anschließend wird das Kondensatordielektrikum durch thermische Oxidation aufgewachsen. Die Abrundung der Kanten verringert Leckströme. Wird nämlich ein thermisches Oxid auf einer Fläche, die eine Kante aufweist, aufgewachsen, fällt das Oxid an der Kante besonders dünn aus, so daß es deshalb zu Leckströmen im Bereich der Kante kommt.

In der deutschen Patentschrift 195 19 160 ist eine DRAM-Zellenanordnung beschrieben, bei der zur Erhöhung ihrer Pakkungsdichte ein Speicherkondensator unterhalb eines Transistors angeordnet ist. Eine Gateelektrode des Transistors und ein Speicherknoten des Kondensators sind in einer Vertiefung angeordnet, die einen quadratischen Querschnitt aufweist. Eine Fläche, an der das Kondensatordielektrikum angeordnet ist, weist Kanten auf.

In der EP 0 852 396 ist eine DRAM-Zellenanordnung beschrieben, bei der für jeweils eine Speicherzelle eine Vertiefung in einem Siliziumsubstrat erzeugt wird. Zunächst werden isolierende Strukturen im Substrat erzeugt. Anschließend werden auf dem Substrat Bitleitungen erzeugt. Obere Bereiche der Vertiefungen werden erzeugt, wobei Silizium selektiv zu den isolierenden Strukturen und den Bitleitungen bis zu einer ersten Tiefe geätzt wird. Anschließend werden Flanken der Vertiefungen mit einer Schicht aus SiO₂ und einer Schicht aus Siliziumnitrid versehen. Durch anisotropes Ätzen bis zu einer zweiten Tiefe, werden untere Bereiche der Vertiefungen erzeugt. Anschließend werden die unteren Bereiche der Vertiefungen durch isotropes Ätzen verbreitert, wobei die Schicht aus SiO₂ und die Schicht aus Siliziumnitrid die oberen Bereiche schützen. Im unteren Bereich der Vertiefung wird ein Speicherkondensator der Speicherzelle erzeugt. Im oberen Bereich der Speicherzelle wird ein Teil einer Wortleitung erzeugt, der als Gateelektrode eines Transistors der Speicherzelle wirkt.

Aus US-A-5,365,097, US-A-5,216,266 und EP-A-0 333 426 sind jeweils Substrate bekannt, bei denen Vertiefungen aus einem aus einem oberen und einem unteren Bereich bestehen, wobei der obere Bereich eine größere Querschnittsfläche als der untere Bereich hat. Diese Bereiche können Speicherkondensatoren und Schalttransistoren von Speicherzellen enthalten.

Der Erfindung liegt das Problem zugrunde, ein Substrat mit einer Vertiefung anzugeben, das für eine integrierte Schaltungsanordnung geeignet ist, wobei die Vertiefung Teil eines Transistors sein kann, der eine Steuerkennlinie aufweisen kann, wie sie üblicherweise bei planaren MOS-Transistoren auftritt, und Teil eines Kondensators mit einer hohen Durchbruchsspannung sein kann. Ferner soll ein Verfahren zu dessen Herstellung angegeben werden.

Das Problem wird gelöst durch ein Substrat mit einer Vertiefung, das für eine integrierte Schaltungsanordnung geeignet ist, bei dem die Vertiefung ausgehend von einer Hauptfläche des Substrats in das Substrat hineinreicht. Die Vertiefung weist einen oberen Bereich und einen daran angrenzenden unteren Bereich auf. Ein zur Hauptfläche paralleler Querschnitt durch den oberen Bereich weist mindestens eine Ecke auf. Ein zur Hauptfläche paralleler Querschnitt durch den unteren Bereich zumindest unmittelbar in der Nähe des oberen Bereichs entspricht dem Querschnitt des oberen Bereichs mit dem Unterschied, daß jede Ecke so abgerundet ist, daß der Querschnitt des unteren Bereichs kleiner als der Querschnitt des oberen Bereichs ist und die Vertiefung beim Übergang von oberen Bereich zum unteren Bereich eine Einbuchtung aufweist.

Das Problem wird ferner gelöst durch ein Verfahren zur Herstellung eines Substrat mit einer Vertiefung, das für eine integrierte Schaltungsanordnung geeignet ist, bei dem die Vertiefung ausgehend von einer Hauptfläche des Substrats im Substrat erzeugt wird. Die Vertiefung wird so erzeugt, daß sie einen oberen Bereich und einen daran angrenzenden unteren Bereich aufweist. Der obere Bereich wird so erzeugt, daß ein zur Hauptfläche paralleler Querschnitt durch den oberen Bereich mindestens eine Ecke aufweist. Der untere Bereich wird so erzeugt, daß ein zur Hauptfläche paralleler Querschnitt durch den unteren Bereich zumindest unmittelbar in der Nähe des oberen Bereichs dem Querschnitt des oberen Bereichs mit dem Unterschied entspricht, daß jede Ecke so abgerundet ist, daß der Querschnitt des unteren Bereichs kleiner als der Querschnitt des oberen Bereichs ist und die Vertiefung beim Übergang von oberen Bereich zum unteren Bereich eine Einbuchtung aufweist.

Das Substrat kann eine integrierte Schaltungsanordnung umfassen, bei der eine seitliche erste Fläche der Vertiefung, die im oberen Bereich liegt, Teil eines ersten Bauelements der Schaltungsanordnung und eine seitliche zweite Fläche der Vertiefung, die im unteren Bereich liegt, Teil eines zweiten Bauelements der Schaltungsanordnung sein können. Da das erste Bauelement und das zweite Bauelement untereinander angeordnet sind, kann die Schaltungsanordnung eine hohe Packungsdichte aufweisen.

Da der Querschnitt des oberen Bereichs mindestens eine Ecke aufweist, kann der Querschnitt einen geradlinigen Rand aufweisen und die erste Fläche, die dem Rand zugeordnet ist, eben sein. Der Querschnitt wird in diesem Fall mindestens zwei Ecken aufweisen, mit denen des Rand abschließt. Die zweite Fläche ist unter der ersten Fläche angeordnet. Im Querschnitt des unteren Bereichs sind beide Ecken abgerundet. Folglich ist die zweite Fläche gekrümmt.

Der Erfindung liegt die Erkenntnis zugrunde, daß das Wachstum einer durch thermische Oxidation erzeugten Oxidschicht auf einer Fläche eines Substrats von der Ausrichtung der Fläche relativ zur Kristallstruktur des Substrats abhängt. Ist die Fläche eben, wächst die Oxidschicht mit einer homogenen Dikke, da die ebene Fläche im Gegensatz zu einer gekrümmten Fläche eine definierte Ausrichtung relativ zur Kristallstruktur des Substrats aufweist. Handelt es sich bei der Oxidschicht um ein Gatedielektrikum eines MOS-Transistors, weist das Gatedielektrikum, das auf der gekrümmten Fläche aufgewachsen wird, keine homogene Dicke auf, so daß unterschiedliche Bereiche des Transistors unterschiedliche Einsatzspannungen haben, die zu inhomogenem Abschaltverhalten und damit zu ungünstigen Steuerkennlinien des Transistors, die eine geringere Unterschwellensteilheit aufweisen, führen. Da die erste Fläche eben ist, kann das erste Bauelement ein vertikaler Transistor sein, dessen Steuerkennlinie hinsichtlich des Abschaltverhaltens der eines herkömmlichen planaren MOS-Transistors entspricht.

Das zweite Bauelement kann beispielsweise ein Kondensator sein, dessen Kondensatordielektrikum auf der zweiten Fläche angeordnet ist.

Die gekrümmte zweite Fläche ermöglicht es, daß der untere Bereich der Vertiefung keine Kanten aufweist, was zum Beispiel der Fall ist, wenn sämtliche Ecken im Querschnitt des unteren Bereichs abgerundet sind. Dies ist vorteilhaft, da das Kondensatordielektrikum dann ebenfalls keine Kanten aufweist, und damit kantenbedingte Dünnstellen des Kondensatordielektrikums sowie Feldverzerrungen, die zu Senkung der Durchbruchsspannung des Kondensators führen, vermieden werden. Außerdem kann das Kondensatordielektrikum leichter erzeugt werden, wenn keine Kanten bedeckt werden müssen.

Darüber hinaus können Versetzungsdefekte, die während eines Temperaturzyklus durch hohe Kerbspannungen aufgrund unterschiedlicher Ausdehnungskoeffizienten an Kanten erzeugt werden, vermieden werden.

Es kann auch für andere Bauelemente, wie z.B. mikromechanische Sensoren oder Aktuatoren, vorteilhaft sein, an einer ebenen Fläche oder an einer gekrümmten Fläche angeordnet zu sein oder diese zu umfassen. In der Vertiefung kann z.B. eine leitende Struktur angeordnet sein, die im oberen Bereich der Vertiefung als Teil eines Bauelements wirkt und im unteren Bereich der Vertiefung als Kontakt wirkt, der zu einer der Hauptfläche abgewandten Fläche des Substrats führt.

Die Erfindung ist nicht nur für eine integrierte Schaltungsanordnung geeignet. Es kann zum Beispiel auch aus mechanischen Gründen vorteilhaft sein, wenn eine Vertiefung eine ebene erste Fläche und eine gekrümmte zweite Fläche aufweist, die untereinander angeordnet sind. In der Vertiefung kann z.B. eine Verbindungsstruktur angeordnet sein, die das Substrat mit einem anderen Substrat verbindet.

Ein erfindungsgemäßes Substrat läßt sich beispielsweise erzeugen, indem nach Erzeugung des oberen Bereichs ein Hilfsspacer in der Vertiefung erzeugt wird, indem Material abgeschieden und geätzt wird. Durch isotropes Ätzen des Hilfsspacers werden seine Kanten abgerundet, so daß ein freiliegender Teil eines Bodens der Vertiefung, der an den Hilfsspacer angrenzt, keine Ecken aufweist. Anschließend wird der untere Bereich erzeugt, indem das Substrat selektiv zum Hilfsspacer geätzt wird. Unter dem Hilfsspacer wird die zur Hauptfläche im wesentlichen parallele Fläche der Vertiefung erzeugt.

Beim Abrunden der Kanten des Hilfsspacers können Teile des oberen Bereichs der Vertiefung freigelegt werden, die nicht in der Nähe der Kanten des oberen Bereichs liegen. Der Hilfsspacer zerfällt dann in Teile, die in Kanten der oberen Bereiche angeordnet sind.

Es liegt im Rahmen der Erfindung, wenn der obere Bereich zusätzlich zur ersten Fläche gekrümmte seitliche Flächen aufweist.

Es liegt im Rahmen der Erfindung, wenn der Hilfsspacer vor Erzeugung des unteren Bereichs teilweise entfernt wird, so daß ausgewählte Teile des Flächen des oberen Bereichs und des unteren Bereichs ohne Stufe, d.h. ohne Einbuchtung, ineinander übergehen.

Zur Erhöhung der Packungsdichte ist es vorteilhaft, wenn die erste Fläche, die seitlich durch Kanten der Vertiefung begrenzt ist, eine zur Hauptfläche parallele Abmessung aufweist, die nicht größer als die minimale in der verwendeten Technologie herstellbare Strukturgröße F ist.

Zur Erhöhung der Packungsdichte ist es vorteilhaft, wenn der Querschnitt des oberen Bereichs im wesentlichen quadratisch ist. Die Seitenlänge des Quadrats beträgt vorzugsweise F. Der Querschnitt des unteren Bereichs ist im wesentlichen kreisförmig, wobei ein Durchmesser gleich oder kleiner als F ist. Der untere Bereich der Vertiefung ist zum Beispiel zylinderförmig.

Durch einen bloßen maskierten photolithographischen Ätzprozeß ist ein solcher oberer Bereich schwer zu erzeugen, da bei diesen kleinen Abmessungen eine Unschärfe der Photolithographie zur Verrundung von Kanten führt, so daß die erste Fläche gekrümmt ist. Es liegt im Rahmen der Erfindung, den oberen Bereich zu erzeugen, indem zunächst mit Hilfe einer streifenförmigen ersten Maske zwei Gräben erzeugt werden. Ein Abstand zwischen den Gräben beträgt vorzugsweise F. Anschließend werden die Gräben mit Strukturen gefüllt. Dazu kann beispielsweise SiO₂ abgeschieden und rückgeätzt werden. Nach Erzeugung der Strukturen wird das Substrat mit Hilfe einer streifenförmigen zweiten Maske selektiv zu den Strukturen geätzt. Die zweite Maske weist mindestens zwei Streifen auf, der quer zu den Gräben verlaufen und deren Abstand voneinander vorzugsweise F beträgt. Auf diese Weise wird zwischen den Gräben und zwischen den Streifen der obere Bereich der Vertiefung erzeugt, der Kanten aufweist. Der obere Bereich kann auch mit einem anderen Verfahren so erzeugt werden, daß sein Querschnitt quadratisch mit einer Seitenlänge von F ist.

Es liegt im Rahmen der Erfindung, wenn der Abstand der Gräben und der Abstand der Streifen der zweiten Maske größer als F betragen und damit der Querschnitt der oberen Bereichs größer als F² ist.

Das Substrat kann eine DRAM-Zellenanordnung umfassen. Die Vertiefung ist Teil einer Speicherzelle, die einen vertikalen Transistor und einen dazu in Reihe geschalteten Speicherkondensator umfaßt. Der untere Bereich der Vertiefung ist mit einem Kondensatordielektrikum versehen. Ein Speicherknoten des Speicherkondensators ist zum größten Teil im unteren Bereich angeordnet. Der obere Bereich der Vertiefung ist mit einem Gatedielektrikum versehen. Eine Gateelektrode des Transistors ist im oberen Bereich an mindestens der ersten Fläche angeordnet. Ein unteres Source/Drain-Gebiet des Transistors ist im Substrat angeordnet und mit dem Speicherknoten elektrisch verbunden. Ein oberes Source/Drain-Gebiet des Transistors ist mit einer Bitleitung verbunden. Die Gateelektrode ist mit einer Wortleitung verbunden. Die Wortleitung und die Bitleitung sind vorzugsweise über der Hauptfläche angeordnet, damit sie aus Materialien mit hohen elektrischen Leitfähigkeiten erzeugt und zusammen mit Gateelektroden von Transistoren einer Peripherie der Zellenanordnung strukturiert werden können.

Das Substrat kann ein Halbleitersubstrat, das zum Beispiel Silizium oder Germanium enthält, sein.

Im folgenden wird ein Ausführungsbeispiel der Erfindung anhand der Figuren näher erläutert.
- Figur 1a: zeigt einen Querschnitt durch ein Substrat, nachdem eine erste Schicht, eine zweite Schicht, eine dritte Schicht, eine vierte Schicht und Trennstrukturen, erzeugt wurden.
- Figur 1b: zeigt den Querschnitt aus Figur 1a, nachdem die vierte Schicht entfernt wurde und Hilfsstrukturen erzeugt wurden.
- Figur 2a: zeigt eine Aufsicht auf das Substrat aus Figur 1b, nachdem obere Bereiche von Vertiefungen und die Hilfsspacer erzeugt wurden. Ferner ist die Lage einer Fotolackmaske dargestellt.
- Figur 2b: zeigt einen zum Querschnitt aus Figur 1a senkrechten Querschnitt durch das Substrat nach den Prozeßschritten aus Figur 2a.
- Figur 3: zeigt die Aufsicht aus Figur 2a, nachdem die Hilfsspacer abgerundet wurden.
- Figur 4: zeigt den Querschnitt aus Figur 2b, nachdem ein unterer Bereich der Vertiefung, ein Kondensatordielektrikum, ein Speicherknoten und eine Photolackmaske erzeugt wurden.
- Figur 5: zeigt den Querschnitt aus Figur 4, nachdem ein Gatedielektrikum, obere Source/Drain-Gebiete, untere Source/Drain-Gebiete, eine fünfte Schicht, eine sechste Schicht und eine siebte Schicht erzeugt wurden.
- Figur 6a: zeigt den Querschnitt aus Figur 5, nachdem die fünften Schicht und die sechsten Schicht zu Wortleitungen strukturiert wurden, und Spacer, eine Isolation (in Figur 6b dargestellt), eine achte Schicht und eine neunte Schicht, die Bitleitungen bilden, und eine zehnte Schicht erzeugt wurden.
- Figur 6b: zeigt einen zum Querschnitt aus Figur 6a parallelen Querschnitt durch das Substrat nach den Prozeßschritten aus Figur 6a.

Die Figuren sind nicht maßstabsgerecht.

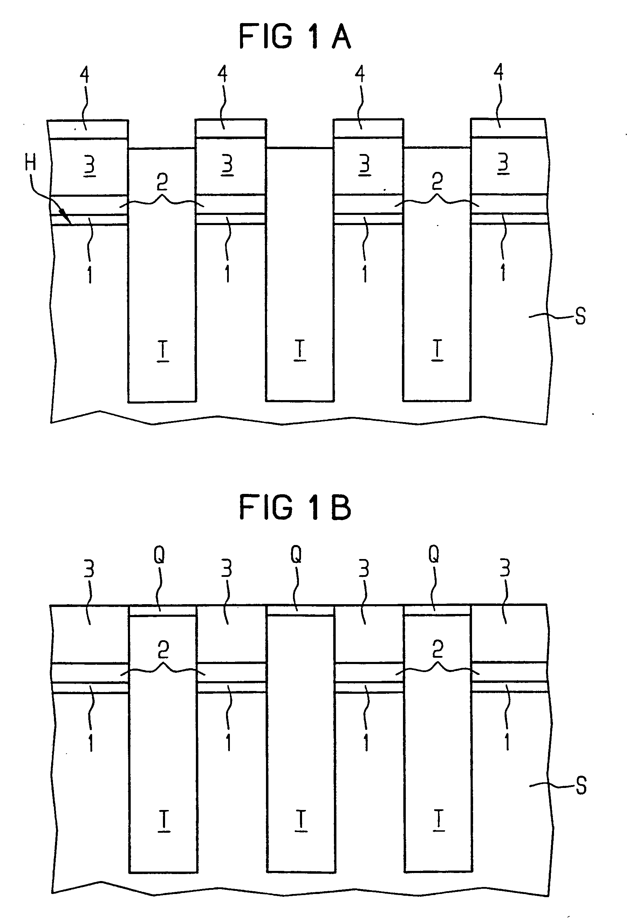

In einem Ausführungsbeispiel ist als Ausgangsmaterial ein p-dotiertes Substrat S aus Silizium vorgesehen, das in einer an einer Hauptfläche H des Substrats S angrenzenden Schicht mit einer Dotierstoffkonzentration von ca. 10¹⁸ cm⁻³ p-dotiert ist. Auf der Hauptfläche H wird eine ca. 20 nm dicke erste Schicht 1 aus SiO₂, darüber eine ca. 100 nm dicke zweite Schicht 2 aus Siliziumnitrid, darüber eine ca. 800 nm dicke dritte Schicht 3 aus SiO₂ und darüber eine ca. 100 nm dicke vierte Schicht 4 aus Siliziumnitrid abgeschieden (siehe Figur 1a).

Mit Hilfe einer streifenförmigen ersten Photolackmaske (nicht dargestellt) werden die vierte Schicht 4, die dritte Schicht 3, die zweite Schicht 2, die erste Schicht 1 und das Substrat S anisotrop geätzt, so daß im Substrat S ca. 300 nm tiefe erste Gräben erzeugt werden, die eine Breite von ca. 100 nm und Abstände von ca. 100 nm voneinander aufweisen. Als Ätzmittel sind zum Beispiel CF₄, CHF₃, C₂F₆ und HBr geeignet, die entsprechend dem zu ätzenden Material kombiniert werden.

In den ersten Gräben werden Trennstrukturen T erzeugt, indem SiO₂ in einer Dicke von ca. 200 nm konform abgeschieden und durch chemisch-mechanisches Polieren planarisiert wird, bis eine obere Fläche der vierten Schicht 4 freigelegt wird. Anschließend wird SiO₂ selektiv zum Siliziumnitrid rückgeätzt, so daß eine obere Fläche der Trennstrukturen T unterhalb einer oberen Fläche der dritten Schicht 3 liegt (siehe Figur 1a).

Anschließend wird Siliziumnitrid abgeschieden und durch chemisch-mechanisches Polieren planarisiert, bis die obere Fläche der dritten Schicht 3 freigelegt wird. Auf diese Weise sind über den Trennstrukturen T Hilfsstrukturen Q aus Siliziumnitrid angeordnet (siehe Figur 1b).

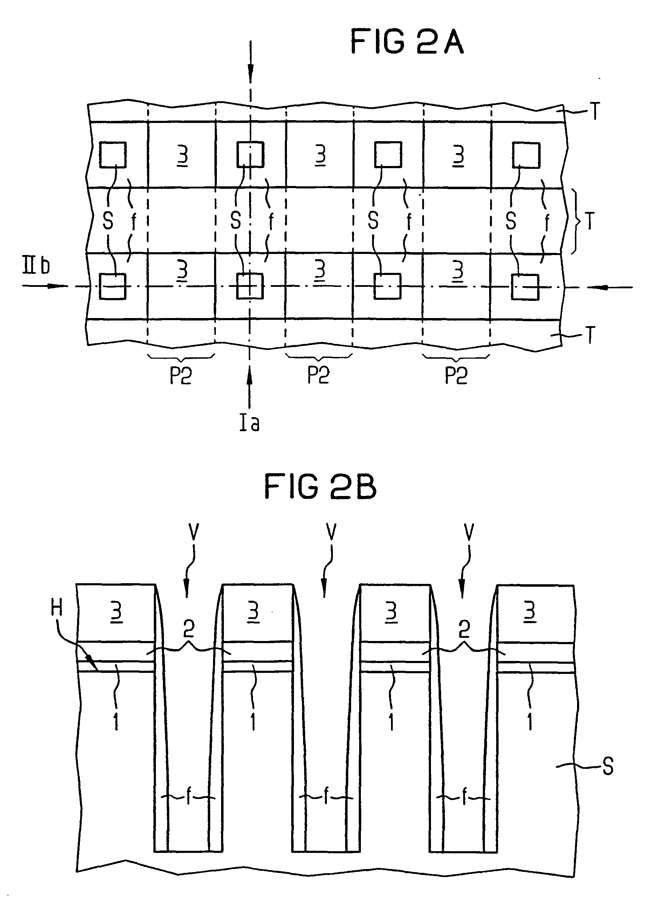

Mit Hilfe einer streifenförmigen zweiten Photolackmaske P2 (siehe Figur 2a), deren Streifen quer zu den Streifen der ersten Photolackmaske verlaufen, wird SiO₂ selektiv zu Siliziumnitrid mit zum Beispiel C₄F₆, CO geätzt, bis die zweite Schicht 2 teilweise freigelegt wird. Anschließend wird Siliziumnitrid geätzt, so daß die Hilfsstrukturen Q und freiliegende Teile der zweiten Schicht 2 entfernt werden. Durch Ätzen von Silizium selektiv zu SiO₂ wird aufgrund der endlichen Selektivität des Ätzprozesses zunächst die erste Schicht 1 teilweise durchtrennt und anschließend obere Bereiche von Vertiefungen V erzeugt. Dabei wirken die Trennstrukturen T und die dritte Schicht 3 als dicke Maske. Die oberen Bereiche der Vertiefungen V sind ca. 300 nm tief im Substrat S und weisen zur Hauptfläche H parallele Querschnitte auf, die quadratisch sind und deren Abmessungen ca. 100 nm betragen. Abstände zwischen zueinander benachbarten Vertiefungen V betragen ca. 100 nm voneinander (siehe Figuren 2a und 2b).

In den Vertiefungen V werden Hilfsspacer f erzeugt, indem SiO₂ in einer Dicke von ca. 30 nm abgeschieden und anisotrop rückgeätzt wird (siehe Figuren 2a und 2b). Freiliegende Teile der Böden der Vertiefungen sind im wesentlichen quadratisch und weisen eine Seitenlänge von ca. 40 nm auf.

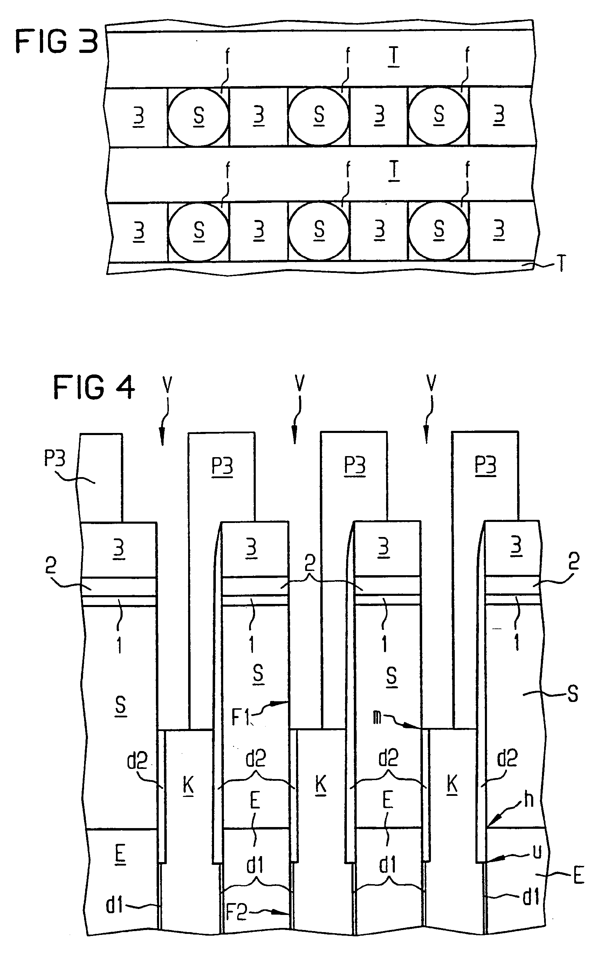

Zum Abrunden der Hilfsspacer f wird anschließend eine isotrope Rückätzung mit zum Beispiel CF₄ als Ätzmittel durchgeführt (siehe Figur 3). Freiliegende Teile der Böden der Vertiefungen V sind im wesentlichen kreisförmig und weisen einen Durchmesser von ca. 100 nm auf.

Anschließend wird Silizium selektiv zu SiO₂ mit zum Beispiel HBr anisotrop geätzt, so daß untere Bereiche der Vertiefungen V entstehen, die aufgrund der als Maske wirkenden Hilfsspacer f kreisförmige horizontale Querschnitte aufweisen. Die Vertiefungen V sind nun ca. 7 µm tief (siehe Figur 4). Beim Ätzen wirken die Trennstrukturen T und die dritte Schicht 3 als dicke Maske.

Die oberen Bereiche der Vertiefungen V weisen jeweils vier seitliche ebene erste Flächen F1 auf. Die unteren Bereiche der Vertiefungen V weisen eine gekrümmte zweite Fläche F2 auf. Ein horizontaler, d.h. parallel zur Hauptfläche H liegender Querschnitt des unteren Bereichs einer der Vertiefungen V weist einen gekrümmten Rand auf. Ein Teil des Substrats S ist insbesondere unter Ecken der oberen Bereiche der Vertiefungen V angeordnet, da die Hilfsspacer f mindestens die Ecken bedecken und dort folglich nicht tiefer geätzt wird. Beim Übergang vom oberen Bereich zum unteren Bereich weist die Vertiefung V Einbuchtungen auf.

Zur Erzeugung einer Kondensatorelektrode E von Kondensatoren wird Arsenglas in einer Dicke von ca. 10 nm abgeschieden. Die mit dem Arsenglas versehenen Vertiefungen V werden bis zu einer Höhe h von ca. 1 µm unter der Hauptfläche H (vergleiche Fig. 4) mit Photolack gefüllt. Anschließend wird freiliegendes Arsenglas entfernt. Nach Entfernung des Photolacks wird ein Schutzoxid (nicht dargestellt) aufgewachsen. Das Schutzoxid verhindert, daß bei einem folgenden Temperschritt bei ca. 1000°C, bei dem Arsen aus dem Arsenglas in das Substrat S diffundiert, Arsen verdampft. Dadurch wird die Kondensatorelektrode E als ein mit Arsen dotierter Teil des Substrats S erzeugt, die Teile der unteren Bereiche der Vertiefungen V umgibt (siehe Figur 4). Das Schutzoxid und die Hilfsspacer f werden anschließend mit verdünnter Flußsäure entfernt.

Zur Erzeugung eines ersten Teils d1 eines Kondensatordielektrikums werden Flächen der Vertiefungen V mit Siliziumnitrid versehen, das anschließend teilweise aufoxidiert wird, so daß der erste Teil d1 des Kondensatordielektrikums als sogenannte NO-Schicht mit einer ca. 3 nm oxidäquivalenten Dicke erzeugt wird (siehe Figur 4).

Zur Erzeugung von Speicherknoten K der Kondensatoren wird in situ dotiertes Polysilizium in einer Dicke von ca. 100 nm abgeschieden und durch chemisch-mechanisches Polieren planarisiert, bis die zweite Schicht 2 freigelegt wird. Dabei wird die dritte Schicht 3 entfernt und die Trennstrukturen T etwas abgetragen. Anschließend wird das Polysilizium bis zu einer Tiefe von 1,1 µm unterhalb der Hauptfläche H durch anisotropes Ätzen rückgeätzt, so daß die Vertiefungen V bis zu einer unteren Höhe u mit Polysilizium gefüllt werden (siehe Figur 4). Freiliegende Teile des ersten Teils d1 des Kondensatordielektrikums werden mit zum Beispiel Flußsäure entfernt.

Zur Erzeugung eines spacerförmigen zweiten Teils d2 des Kondensatordielektrikums in den Vertiefungen V wird SiO₂ in einer Dicke von ca. 15 nm abgeschieden und anisotrop rückgeätzt (siehe Figur 4). Der zweite Teil d2 des Kondensatordielektrikums ist dicker als der erste Teil d1.

Durch Abscheiden von in situ dotiertem Polysilizium in einer Dicke von ca. 100 nm und anschließendem Rückätzen bis zu einer Tiefe von ca. 250 nm unterhalb der Hauptfläche H werden die Speicherknoten K vergrößert. Die Vertiefungen V sind bis zu einer mittleren Höhe m mit Polysilizium gefüllt (siehe Figur 4).

Mit Hilfe einer mehrschichtigen dritten Fotolackmaske P3 (siehe Figur 4) werden Teile des zweiten Teils d2 des Kondensatordielektrikums entfernt. An ersten Flanken der Vertiefungen V reicht der zweite Teil d2 des Kondensatordielektrikums nur von der unteren Höhe u bis zur mittleren Höhe m.

Anschließend wird in situ dotiertes Polysilizium in einer Dicke von ca. 100 nm abgeschieden und durch chemisch-mechanisches Polieren planarisiert, bis die zweite Schicht 2 freigelegt wird.

Unter der ersten Schicht 1 werden durch Implantation mit n-dotierenden Ionen im Substrat S ca. 30 nm dicke obere Source/Drain-Gebiete S/D1 von vertikalen Transistoren erzeugt. Aufgrund der Trennstrukturen T und der Vertiefungen V weisen die oberen Source/Drain-Gebiete S/D1 quadratische horizontale Querschnitte mit einer Seitenlänge von ca. 100 nm auf. Zueinander benachbarte obere Source/Drain-Gebiete S/D1 sind durch die Trennstrukturen T oder durch die Vertiefungen V voneinander getrennt.

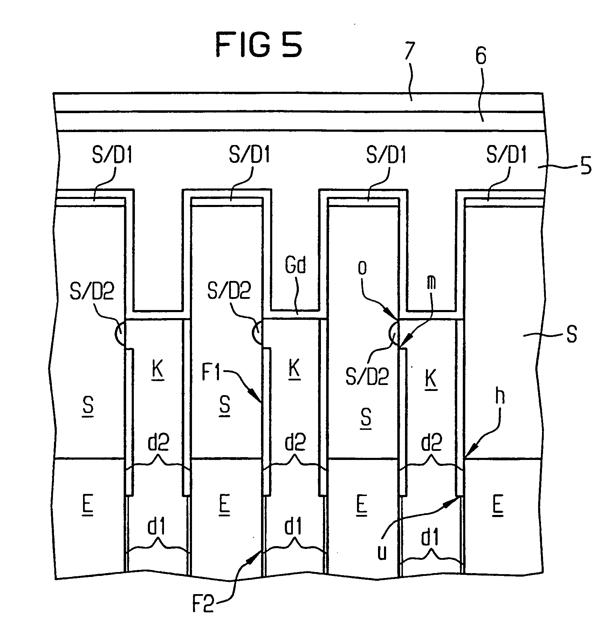

Das Polysilizium wird anschließend bis zu einer Tiefe von ca. 200 nm unterhalb der Hauptfläche H rückgeätzt, so daß die Speicherknoten K weiter verdickt werden. Die Vertiefungen V sind bis zu einer oberen Höhe h mit Polysilizium gefüllt (siehe Figur 5). Die Speicherknoten K grenzen bei den ersten Flanken der Vertiefungen V zwischen der mittleren Höhe m und der oberen Höhe o an das Substrat S an. Obere Teile der Speicherknoten K sind in den oberen Bereichen der Vertiefungen V angeordnet. Durch einen Temperschritt diffundiert Dotierstoff aus dem Speicherknoten K in das Substrat S, so daß untere Source-/Drain-Gebiete S/D2 der Transistoren erzeugt werden, die im Bereich zwischen der mittleren Höhe m und der oberen Höhe o an die ersten Flanken der Vertiefungen V angrenzen.

Anschließend wird die zweite Schicht 2 mit zum Beispiel wei-ßer Phosphorsäure als Ätzmittel entfernt.

Durch thermische Oxidation wird ein Gatedielektrikum Gd an Flanken der oberen Bereiche der Vertiefungen V, auf der Hauptfläche H und auf den Speicherknoten K erzeugt (siehe Figur 5).

Anschließend wird eine fünfte Schicht 5 aus in situ dotiertem Polysilizium in einer Dicke von ca. 60 nm abgeschieden, so daß die oberen Bereiche der Vertiefungen V gefüllt werden. Darüber wird eine ca. 50 nm dicke sechste Schicht 6 aus Wolframsilizid und eine ca. 100 nm dicke siebte Schicht 7 aus Siliziumnitrid abgeschieden (siehe Figur 5).

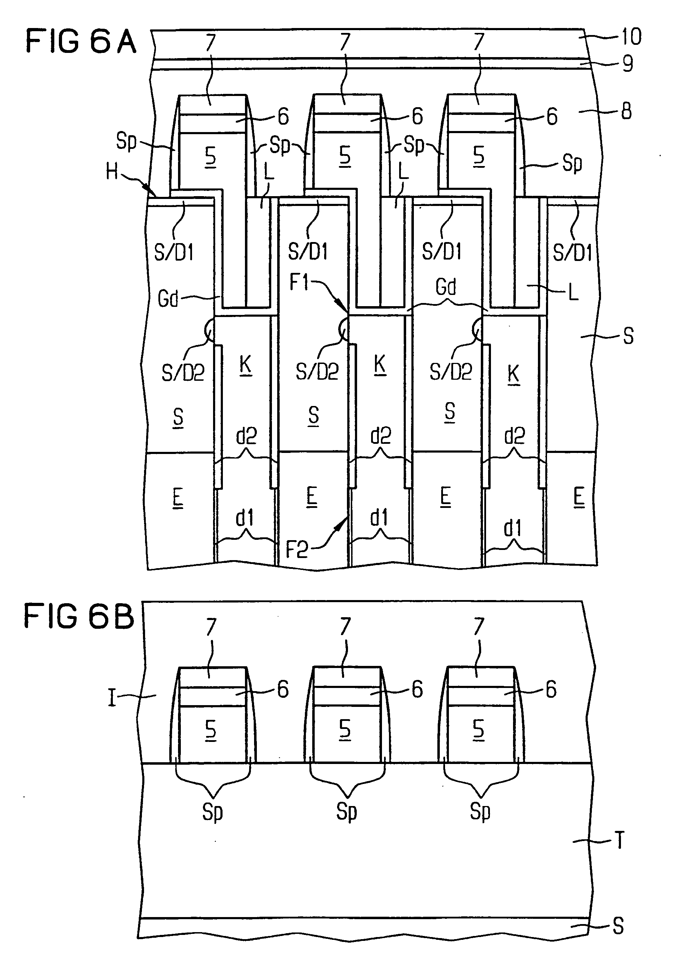

Mit Hilfe einer streifenförmigen vierten Photolackmaske (nicht dargestellt), deren Streifen quer zu den Trennstrukturen T verlaufen, werden die siebte Schicht 7, die sechste Schicht 6 und die fünfte Schicht 5 geätzt, bis das Gatedielektrikum Gd freigelegt wird. Jeweils ein Teil der fünften Schicht 5 und ein Teil der sechsten Schicht 6, die aneinander grenzen bilden eine Wortleitung, die von der isolierenden siebten Schicht 7 bedeckt wird (siehe Figur 6a). Die Wortleitungen sind ca. 100 nm breit und weisen einen Abstand von ca. 100 nm voneinander auf. Die Wortleitungen sind versetzt zu den Vertiefungen V angeordnet, so daß erste Teile der Wortleitungen einen streifenförmigen horizontalen Querschnitt aufweisen und über Teilen der vom Gatedielektrikum Gd bedeckten oberen Source/Drain-Gebiete S/D1 verlaufen. Zweite Teile der Wortleitungen sind in den oberen Bereichen der Vertiefungen V an deren ersten Flanken angeordnet. Die Wortleitungen haben eine metallische Leitfähigkeit.

Zur Erzeugung von isolierenden Strukturen L in den Vertiefungen V wird SiO₂ in einer Dicke von ca. 50 nm abgeschieden und rückgeätzt, bis das Gatedielektrikum Gd, das aufgrund seiner Dichte schlechter ätzbar ist, freigelegt wird (siehe Figur 6a).

Zum Abkapseln der Wortleitungen werden Spacer Sp erzeugt, indem Siliziumnitrid in einer Dicke von ca. 15 nm abgeschieden und anisotrop rückgeätzt wird (siehe Figur 6a).

Zur Erzeugung einer Isolation I wird SiO₂ in einer Dicke von ca. 50 nm abgeschieden und durch chemisch-mechanisches Polieren planarisiert, bis eine ebene Fläche entsteht (siehe Figur 6b).

Mit Hilfe einer streifenförmigen fünften Photolackmaske (nicht dargestellt), deren Streifen jeweils über einer der Trennstrukturen T angeordnet sind, wird SiO₂ geätzt, bis die oberen Source/Drain-Gebiete S/D1 freigelegt werden und zweite Gräben in der Isolation I entstehen, die in Bereichen zwischen den Wortleitungen besonders tief sind und Kontaktlöcher bilden (siehe Figur 6a). Dabei werden Teile des Gatedielektrikums Gd entfernt. Die isolierende siebte Schicht 7 und die Spacer Sp schützen dabei die Wortleitungen, so daß sich für die zweiten Gräben eine große Justiertoleranz ergibt.

Zur Erzeugung von Bitleitungen wird eine achte Schicht 8 aus in situ dotiertem Polysilizium in einer Dicke von ca. 50 nm abgeschieden, so daß die zweiten Gräben gefüllt werden. Anschließend wird das Polysilizium rückgeätzt, bis ca. 30nm Polysilizium über der siebten Schicht liegt. Darüber wird eine ca. 20 nm dicke neunte Schicht 9 aus Titannitrid und Titan und eine ca. 60 nm dicke zehnte Schicht 10 aus Wolfram abgeschieden und durch chemisch-mechanisches Polieren planarisiert, bis die Isolation I freigelegt wird, so daß selbstjustiert in den zweiten Gräben aus der achten Schicht 8, der neunten Schicht 9 und der zehnten Schicht 10 Bitleitungen erzeugt werden. Erste Teile der Bitleitungen bilden Streifen, die quer zu den Wortleitungen verlaufen, und zweite Teile der Bitleitungen füllen die Kontaktlöcher und sind zwischen zueinander benachbarten Wortleitungen angeordnet (siehe Figur 6a). Die Bitleitungen haben metallische Leitfähigkeit.

Im Ausführungsbeispiel wird eine DRAM-Zellenanordnung erzeugt. Eine Speicherzelle umfaßt einen der vertikalen Transistoren und einen der Kondensatoren, der zum Transistor in Reihe geschaltet ist. Das Gatedielektrikum des Transistors ist an einer der ebenen ersten Flächen F1 angeordnet. Der ersten Teil des Kondensatordielektrikums ist an der gekrümmten zweiten Fläche F2 angeordnet.

Teile der Wortleitungen, die an den ersten Flanken der oberen Bereiche der Vertiefungen V angeordnet sind, wirken als Gateelektroden der Transistoren. Die isolierenden Strukturen L an den zweiten Flanken der Vertiefungen V verhindern, daß die in der Vertiefung V angeordnete Wortleitung einen Transistor ansteuert, der an einer zur Vertiefung V benachbarten Vertiefung V angeordnet ist.

Kanalgebiete der Transistoren sind Teile des Substrats S, die zwischen den oberen Source/Drain-Gebieten S/D1 und den unteren Source/Drain-Gebieten S/D2 angeordnet sind. Die Kanalgebiete der Transistoren sind miteinander verbunden, so daß aufgrund der genügend hohen Dotierstoffkonzentration der an die Hauptfläche H angrenzenden Schicht des Substrats S Floating-Body-Effekte vermieden werden.

Es sind viele Variationen des Ausführungsbeispieles denkbar, die ebenfalls im Rahmen der Erfindung liegen. So können Abmessungen der Schichten, Vertiefungen und Strukturen an die jeweiligen Erfordernisse angepaßt werden. Dasselbe gilt für die Dotierstoffkonzentrationen und für die Wahl von Materialien. So können die Wortleitungen und die Bitleitungen auch andere leitende Materialien als die im Ausführungsbeispiel angeführten enthalten.

Das untere Source/Drain-Gebiet eines der Transistoren kann zweigeteilt sein, so daß ein erster Teil an die erste Flanke und ein zweiter Teil an die zweite Flanke der zugehörigen Vertiefung angrenzt. In diesem Fall wird beim Entfernen des zweiten Teils des Kondensatordielektrikums bis zur mittleren Höhe keine Maske verwendet, so daß der zweite Teil des Kondensatordielektrikums an den zweiten Flanken der Vertiefungen ebenfalls bis zur mittleren Höhe entfernt wird. Der Speicherknoten grenzt sowohl bei der ersten Flanke als auch bei der zweiten Flanke an das Substrat an.

Auf die isolierenden Strukturen kann verzichtet werden, wenn der Abstand der zweiten Flanke der Vertiefung zum unteren Source/Drain-Gebiet des Transistors der benachbarten Vertiefung groß genug ist.

Sind die isolierenden Strukturen vorgesehen, können die unteren Source/Drain-Gebiete statt durch Ausdiffusion von Dotierstoff durch Strukturierung einer dotierten Schicht des Substrats erzeugt werden.

Die isolierenden Strukturen können erzeugt werden, indem bei der Abkapselung der Wortleitungen das Siliziumnitrid in einer solchen Dicke abgeschieden wird, daß sich die Vertiefungen füllen. In diesem Fall bestehen die isolierenden Strukturen aus Siliziumnitrid.

## Patentansprüche

1. Substrat mit einer Vertiefung, das für eine integrierte Schaltungsanordnung geeignet ist,
- bei dem die Vertiefung (V) ausgehend von einer Hauptfläche (H) des Substrats (S) in das Substrat (S) hineinreicht,
- bei dem die Vertiefung (V) einen oberen Bereich und einen daran angrenzenden unteren Bereich aufweist,
- bei dem ein zur Hauptfläche (H) paralleler Querschnitt durch den oberen Bereich mindestens eine Ecke aufweist,
- bei dem ein zur Hauptfläche (H) paralleler Querschnitt durch den unteren Bereich zumindest unmittelbar in der Nähe des oberen Bereichs dem Querschnitt des oberen Bereichs entspricht, wobei der Querschnitt des unteren Bereichs kleiner als der Querschnitt des oberen Bereichs ist und die Vertiefung (V) beim Übergang vom oberen Bereich zum unteren Bereich eine Einbuchtung aufweist,
**dadurch gekennzeichnet,**
- **dass** der zur Hauptfläche (H) parallele Querschnitt durch den unteren Bereich zumindest unmittelbar in der Nähe des oberen Bereichs dem Querschnitt des oberen Bereichs mit dem Unterschied entspricht, dass jede Ecke so abgerundet ist, dass der Querschnitt des unteren Bereichs kleiner als der Querschnitt des oberen Bereichs ist und die Vertiefung (V) beim Übergang vom oberen Bereich zum unteren Bereich die Einbuchtung aufweist,
- **dass** der Querschnitt des oberen Bereichs quadratisch ist, und
- **dass** der Querschnitt des unteren Bereichs kreisförmig ist.

2. Substrat nach Anspruch 1,
**dadurch gekennzeichnet,**
**dass** zur Hauptfläche (H) parallele Abmessungen des oberen Bereichs nicht größer als die minimale in der verwendeten Technologie herstellbare Strukturgröße sind.

3. Substrat nach Anspruch 1 oder 2,
**dadurch gekennzeichnet,**
- **dass** der untere Bereich mit einem Kondensatordielektrikum (d1, d2) versehen ist,
- **dass** mindestens ein Teil eines Speicherknotens (K) eines Kondensators im unteren Bereich angeordnet ist,
- **dass** der Querschnitt des oberen Bereichs einen geradlinigen Rand aufweist, an den sich die Ecke anschließt,
- **dass** mindestens ein Teil einer seitlichen Fläche (F1) des oberen Bereichs, der dem geradlinigen Rand zugeordnet ist, eben ist und mit einem Gatedielektrikum (Gd) versehen ist, und
- **dass** eine Gateelektrode eines vertikalen Transistors im oberen Bereich an das Gatedielektrikum (Gd) angrenzt.

4. Substrat nach Anspruch 3,
**dadurch gekennzeichnet,**
- **dass** ein unteres Source/Drain-Gebiet (S/D2) des Transistors im Substrat (S) angeordnet ist und mit dem Speicherknoten (K) elektrisch verbunden ist, so dass der Transistor und der Kondensator in Reihe geschaltet sind und eine Speicherzelle einer DRAM-Zellenanordnung bilden, die im Substrat (S) angeordnet ist,
- **dass** ein oberes Source/Drain-Gebiet (S/D1) des Transistors mit einer Bitleitung verbunden ist, und
- **dass** die Gateelektrode mit einer Wortleitung verbunden ist.

5. Verfahren zur Herstellung eines Substrats nach einem der Ansprüche 1 bis 4,
**dadurch gekennzeichnet,**
- **dass** die Vertiefung (V) ausgehend von einer Hauptfläche (H) des Substrats (S) im Substrat (S) erzeugt wird,
- **dass** die Vertiefung (V) so erzeugt wird, dass sie einen oberen Bereich und einen daran angrenzenden unteren Bereich aufweist,
- **dass** der obere Bereich so erzeugt wird, dass ein zur Hauptfläche (H) paralleler Querschnitt durch den oberen Bereich mindestens eine Ecke aufweist und quadratisch ist,
- **dass** der untere Bereich so erzeugt wird, dass ein zur Hauptfläche (H) paralleler Querschnitt durch den unteren Bereich zumindest unmittelbar in der Nähe des oberen Bereichs dem Querschnitt des oberen Bereichs mit dem Unterschied entspricht, dass jede Ecke so abgerundet ist, dass der Querschnitt des unteren Bereichs kreisförmig ist und kleiner als der Querschnitt des oberen Bereichs ist und die Vertiefung (V) beim Übergang vom oberen Bereich zum unteren Bereich eine Einbuchtung aufweist.

6. Verfahren nach Anspruch 5,
**dadurch gekennzeichnet,**
- **dass** nach Erzeugung des oberen Bereichs der Vertiefung (V) ein Hilfsspacer (f) in der Vertiefung (V) erzeugt wird, indem Material abgeschieden und rückgeätzt wird,
- **dass** Kanten des Hilfsspacers (f) durch isotropes Ätzen abgerundet werden und
- **dass** der untere Bereich der Vertiefung (V) erzeugt wird, indem das Substrat (S) selektiv zum Hilfsspacer (f) geätzt wird.

7. Verfahren nach Anspruch 6,
**dadurch gekennzeichnet,**
- **dass** mindestens zwei im Wesentlichen parallel zueinander verlaufende Gräben erzeugt werden,
- **dass** die Gräben mit Trennstrukturen (T) gefüllt werden und
- **dass** das Substrat (S) mit Hilfe einer streifenförmigen Maske (P2), die mindestens zwei Streifen aufweist, die quer zu den Trennstrukturen (T) verlaufen, selektiv zu den Trennstrukturen (T) geätzt wird, so dass zwischen den Gräben und zwischen den zwei Streifen der obere Bereich der Vertiefung (V) erzeugt wird.

8. Verfahren nach Anspruch 7,
**dadurch gekennzeichnet,**
- **dass** der untere Bereich mit einem Kondensatordieletrikum (d1, d2) versehen wird,
- **dass** mindestens ein Teil eines Speicherknotens (K) eines Kondensators im unteren Bereich erzeugt wird,
- **dass** mindestens ein Teil einer seitlichen Fläche (F1) des oberen Bereichs mit einem Gatedielektrikum (Gd) versehen wird, und
- **dass** eine Gateelektrode eines Transistors im oberen Bereich an der seitlichen Fläche (F1) erzeugt wird.

9. Verfahren nach Anspruch 8,
**dadurch gekennzeichnet,**
- **dass** ein unteres Source/Drain-Gebiet (S/D2) des Transistors im Substrat (S) erzeugt und mit dem Speicherknoten (K) elektrisch verbunden wird, so dass der Transistor und der Kondensator in Reihe geschaltet sind und eine Speicherzelle einer DRAM-Zellenanordnung bilden, die im Substrat (S) angeordnet ist,
- **dass** ein oberes Source/Drain-Gebiet (S/D1) des Transistors erzeugt und mit einer Bitleitung verbunden wird, und
- **dass** die Gateelektrode mit einer Wortleitung verbunden wird.

10. Verfahren nach einem der Ansprüche 5 bis 9,
**dadurch gekennzeichnet,**
**dass** die Vertiefung (V) so erzeugt wird, dass zur Hauptfläche (H) parallele Abmessungen des oberen Bereichs im Wesentlichen gleich der minimalen in der verwendeten Technologie herstellbaren Strukturgröße sind.

## Claims

1. Substrate having a depression, which is suitable for an integrated circuit arrangement,
- in which the depression (V) reaches into the substrate (S), starting from a main surface (H) of the substrate (S),
- in which the depression (V) has an upper region and an adjacent lower region,
- in which a cross section through the upper region parallel to the main surface (H) has at least one corner,
- in which a cross section through the lower region parallel to the main surface (H), at least immediately in the vicinity of the upper region, corresponds to the cross section of the upper region, the cross section of the lower region being smaller than the cross section of the upper region and the depression (V) having an indentation at the transition from the upper region to the lower region,
**characterized**
- **in that** the cross section through the lower region parallel to the main surface (H) corresponds to the cross section of the upper region, at least immediately in the vicinity of the upper region, with the difference that each corner is rounded off in such a way that the cross section of the lower region is smaller than the cross section of the upper region and the depression (V) has the indentation at the transition from the upper region to the lower region,
- **in that** the cross section of the upper region is square, and
- **in that** the cross section of the lower region is circular,

2. Substrate according to Claim 1,
**characterized**
**in that** dimensions of the upper region parallel to the main surface (H) are no greater than the minimum structure size which can be fabricated in the technology used.

3. Substrate according to Claim 1 or 2, **characterized**
- **in that** the lower region is provided with a capacitor dielectric (d1, d2),
- **in that** at least part of a storage node (K) of a capacitor is arranged in the lower region,
- **in that** the cross section of the upper region has a straight edge, which the corner adjoins,
- **in that** at least part of a side surface (F1) of the upper region, which is associated with the straight edge, is flat and provided with a gate dielectric (Gd), and
- **in that** a gate electrode of a vertical transistor in the upper region adjoins the gate dielectric (Gd).

4. Substrate according to Claim 3,
**characterized**
- **in that** a lower source/drain region (S/D2) of the transistor is arranged in the substrate (S) and is electrically connected to the storage node (K), so that the transistor and the capacitor are connected in series and form a memory cell of a DRAM cell arrangement which is arranged in the substrate (S),
- **in that** an upper source/drain region (S/D1) of the transistor is connected to a bit line, and
- **in that** the gate electrode is connected to a word line.

5. Method of fabricating a substrate according to one of Claims 1 to 4,
**characterized**
- **in that** the depression (V) is produced in the substrate (S), starting from a main surface (H) of the substrate (S),
- **in that** the depression (V) is generated in such a way that it has an upper region and an adjacent lower region,
- **in that** the upper region is produced in such a way that a cross section through the upper region parallel to the main surface (H) has at least one corner and is square,
- **in that** the lower region is produced in such a way that a cross section through the lower region parallel to the main surface (H) corresponds to the cross section of the upper region, at least immediately in the vicinity of the upper region, with the difference that each corner is rounded off in such a way that the cross section of the lower region is circular and smaller than the cross section of the upper region and the depression (V) has an indentation at the transition from the upper region to the lower region.

6. Method according to Claim 5,
**characterized**
- **in that** after the production of the upper region of the depression (V), an auxiliary spacer (f) is produced in the depression (V), by material being deposited and etched back,
- **in that** edges of the auxiliary spacer (f) are rounded off by isotropic etching, and
- **in that** the lower region of the depression (V) is produced by the substrate (S) being etched selectively with respect to the auxiliary spacer (f).

7. Method according to Claim 6,
**characterized**
- **in that** at least two trenches running substantially parallel to each other are produced,
- **in that** the trenches are filled with isolating structures (T) and
- **in that** the substrate is etched selectively with respect to the isolating structures (T) with the aid of a strip-like mask (P2) which has at least two strips which run transversely with respect to the isolating structures (T), so that the upper region of the depression (V) is produced between the trenches and between the two strips.

8. Method according to Claim 7,
**characterized**
- **in that** the lower region is provided with a capacitor dielectric (d1, d2),
- **in that** at least part of a storage node (K) of a capacitor is produced in the lower region,
- **in that** at least part of a side surface (F1) of the upper region is provided with a gate dielectric (Gd), and
- **in that** a gate electrode of a transistor in the upper region is produced on the side surface (F1).

9. Method according to Claim 8,
**characterized**
- **in that** a lower source/drain region (S/D2) of the transistor is produced in the substrate (S) and is connected electrically to the storage node (K), so that the transistor and the capacitor are connected in series and form a memory cell of a DRAM cell arrangement which is arranged in the substrate (S),
- **in that** an upper source/drain region (S/D1) of the transistor is produced and connected to a bit line, and
- **in that** the gate electrode is connected to a word line.

10. Method according to one of Claims 5 to 9,
**characterized**
**in that** the depression (V) is produced in such a way that dimensions of the upper region parallel to the main surface (H) are substantially equal to the minimum structure size which can be fabricated in the technology used.

## Revendications

1. substrat qui a une cavité et qui convient pour un circuit intégré,
- dans lequel la cavité (V) va en partant d'une surface (H) principale du substrat (S) dans le substrat (S),
- dans lequel la cavité (V) a une partie supérieure et une partie inférieure qui en est voisine,
- dans lequel une section transversale parallèle à la surface (H) principale de la partie supérieure à au moins un coin,
- dans lequel une section transversale parallèle à la surface (H) principale de la partie inférieure, au moins directement à proximité de la partie supérieure, correspond à la section transversale de la partie supérieure, la section transversale de la partie inférieure étant plus petite que la section transversale de la partie supérieure et la cavité (V) ayant une dentelure à la transition de la partie supérieure à la partie inférieure,
**caractérisé**
- **en ce que** la section transversale parallèle à la surface (H) principale de la partie inférieure au moins directement à proximité de la partie supérieure correspond à la section transversale de la partie supérieure à la différence que chaque coin est arrondi, de sorte que la section transversale de la partie inférieure est plus petite que la section transversale de la partie supérieure et la cavité (V) a la dentelure à la transition de la partie supérieure à la partie inférieure,
- **en ce que** la section transversale de la partie supérieure est carrée, et
- **en ce que** la section transversale de la partie inférieure est circulaire.

2. Substrat suivant la revendication 1, **caractérisé en ce que** des dimensions de la partie supérieure, qui sont parallèles à la surface (H) principale, ne sont pas plus grandes que la dimension minimum de structure qui peut être produite par la technologie utilisée.

3. Substrat suivant les revendications 1 ou 2, **caractérisé**
- **en ce que** la partie inférieure est munie d'un diélectrique (d1, d2) de condensateur,
- **en ce qu'**au moins une partie d'un noeud (K) d'un mémoire d'un condensateur est disposée dans la partie inférieure,
- **en ce que** la section transversale de la partie supérieure a un bord rectiligne auquel se raccorde le coin,
- **en ce qu'**au moins une partie d'une surface (F1) latérale de la partie supérieure, qui est associée au bord rectiligne, est plane et est munie d'un diélectrique (Gd) de grille et
- **en ce qu'**une électrode de grille d'un transistor vertical est voisine, dans la partie supérieure, du diélectrique (Gd) de grille.

4. Substrat suivant la revendication 3, **caractérisé**
- **en ce qu'**une zone de source/drain (S/D2) inférieure du transistor est disposée dans le substrat (S) et reliée électriquement au noeud (K) de mémoire, de sorte que le transistor et le condensateur sont montés en série et forment une cellule de mémoire d'un dispositif de cellules DRAM qui est disposé dans le substrat (S),
- **en ce qu'**une zone de source/dràin (S/D1) supérieure du transistor est reliée à une ligne de bits,
- **en ce que** l'électrode de grille est reliée à une ligne de mots.

5. Procédé de production d'un substrat, suivant l'une des revendications 1 à 4, **caractérisé**
- **en ce que** l'on produit la cavité (V) dans le substrat (S) en partant d'une surface (H) principale du substrat,
- **en ce que** l'on produit la cavité (V) de manière à ce qu'elle ait une partie supérieure et une partie inférieure qui en est voisine,
- **en ce que** l'on produit la partie supérieure de façon à ce qu'une section transversale parallèle à la surface (H) principale de la partie supérieure ait au moins un coin et soit carrée,
- **en ce que** l'on produit la partie inférieure de manière à ce qu'une section transversale parallèle à la surface (H) principale de la partie inférieure, au moins directement à proximité de la partie supérieure, correspond à la section transversale de la partie supérieure, à la différence que chaque coin est arrondi, de sorte que la section transversale de la partie inférieure est circulaire et est plus petite que la section transversale de la partie supérieure et la cavité (V) a une dentelure à la transition de la partie supérieure à la partie inférieure.

6. Procédé de production d'un substrat, suivant la revendication 5, **caractérisé**
- **en ce qu'**après la production de la partie supérieure de la cavité V, on produit un espaceur (f) auxiliaire dans la cavité (V) dans lequel on dépose du matériau et on l'attaque en retrait,
- **en ce que** l'on arrondit les arêtes de l'espaceur (f) auxiliaire par attaque isotrope et
- **en ce que** l'on produit la partie inférieure de la cavité (V) en attaquant le substrat (S) sélectivement par rapport à l'espaceur (f) auxiliaire.

7. Procédé de production d'un substrat, suivant la revendication 6, **caractérisé**
- **en ce que** l'on produit au moins deux sillons sensiblement parallèles l'un à l'autre,
- **en ce que** l'on emplit les sillons de structure (T) de séparation et
- **en ce que** l'on attaque sélectivement par rapport aux structures (T) de séparation, le substrat (S) à l'aide d'un masque (P2) en forme de bandes, qui a au moins deux bandes qui s'étendent transversalement aux structures (T) de séparation de manière à produire la partie supérieure de la cavité (V) entre les sillons et entre les deux bandes.

8. Procédé de production d'un substrat, suivant la revendication 7, **caractérisé**
- **en ce que** l'on munit la partie inférieure d'un diélectrique (d1, d2) de condensateur,
- **en ce que** l'on produit au moins une partie d'un noeud (K) de mémoire d'un condensateur dans la partie inférieure,
- **en ce que** l'on munit au moins une partie d'une surface (F1) latérale de la partie supérieure d'un diélectrique (Gd) de grille et
- **en ce que** l'on produit une électrode de grille d'un transistor dans la partie supérieure sur la surface (F1) latérale.

9. Procédé de production d'un substrat, suivant la revendication 8, **caractérisé**
- **en ce que** l'on produit, dans le substrat (S), une zone de source/drain (S/D2) inférieure du transistor et on la relie électriquement au noeud (K) de mémoire, de sorte que le transistor et le condensateur sont montés en série et forment une cellule de mémoire d'un dispositif de cellule DRAM qui est disposée dans le substrat (S),
- **en ce que** l'on produit une zone de source/drain (S/D1) supérieure du transistor et on la relie à une ligne de bits et
- **en ce que** l'on relie l'électrode de grille à une ligne de mots.

10. Procédé de production d'un substrat, sur l'une des revendications 5 à 9, **caractérisé en ce que** l'on produit la qualité (V) de façon à ce que des dimensions, parallèles à la surface (H) principale, de la partie supérieure soient sensiblement égales à la dimension de structure minimum pouvant être produite dans la technologie utilisée.
